# EUROPÄISCHE PATENTSCHRIFT

(11) **EP 1 805 101 B1**
(45) Veröffentlichungstag und Bekanntmachung des Hinweises auf die Patenterteilung: **27.10.2010**
(21) Anmeldenummer: 05787150.1
(22) Anmeldetag: 24.08.2005
(51) Int. Cl.: B81B 7/00, G01L 9/00

(54) **VERFAHREN ZUM MONTIEREN VON HALBLEITERCHIPS UND ENTSPRECHENDE HALBLEITERCHIPANORDNUNG**
METHOD FOR ASSEMBLING SEMICONDUCTOR CHIPS, AND CORRESPONDING SEMICONDUCTOR CHIP ASSEMBLY
PROCEDE POUR MONTER UNE PUCE A SEMI-CONDUCTEUR, ET SYSTEME DE PUCE A SEMI-CONDUCTEUR CORRESPONDANT

(30) Priorität: 22.10.2004 DE 102004051468
(43) Veröffentlichungstag der Anmeldung: 11.07.2007
(73) Patentinhaber: ROBERT BOSCH GMBH, 70442 Stuttgart (DE)
(72) Erfinder: BENZEL, Hubert, 72124 Pliezhausen (DE)
(86) Internationale Anmeldenummer: PCT/EP2005/054165
(87) Internationale Veröffentlichungsnummer: WO 2006/045653

(56) Entgegenhaltungen:
- EP-A- 0 811 831
- EP-A- 1 278 053
- DE-A1- 10 347 215
- DE-A1- 19 902 450
- US-B1- 6 432 737
- KATO S ET AL: "High-precision silicon differential pressure sensor monolithically integrated with twin diaphragms and micro over-range protection structures" PROCEEDINGS IEEE THIRTEENTH ANNUAL INTERNATIONAL CONFERENCE ON MICRO ELECTRO MECHANICAL SYSTEMS, 23-27 JAN. 2000, MIYAZAKI, JAPAN, 23. Januar 2000 (2000-01-23), Seiten 347-351, XP010377151 Piscataway, NJ, USA

## Beschreibung

### STAND DER TECHNIK

Die vorliegende Erfindung begriff ein Verfahren zum Montieren von Halbleiterchips und eine entsprechende Halbleiterchipanordnung.

Obwohl auf beliebige Halbleiterchipanordnungen anwendbar, werden die vorliegende Erfindung sowie die ihr zugrundeliegende Problematik in bezug auf eine mikromechanische Halbleiterchipanordnung mit einem Drucksensor erläutert.

Die Patentanmeldung EP0 811 831 A1 offenbart ein Verfahren zum Montieren eines Differenzdrucksensors mit einem Membran- und einem Peripheriebereich.

Das US Patent US 6 432 737 B1 offenbart ein Verfahren zum Montieren eines Differenzdrucksensor in Flip-Chip-Tehnik.

Die DE 102 004 011 203, veröffentlicht nach dem Anmeldetag der vorliegenden Anmeldung, offenbart verschiedene Beispiele für Verfahren zum Montieren von Halbleiterchips und entsprechende Halbleiterchipanordnungen, von denen nachstehend drei Beispiele näher erläutert werden.

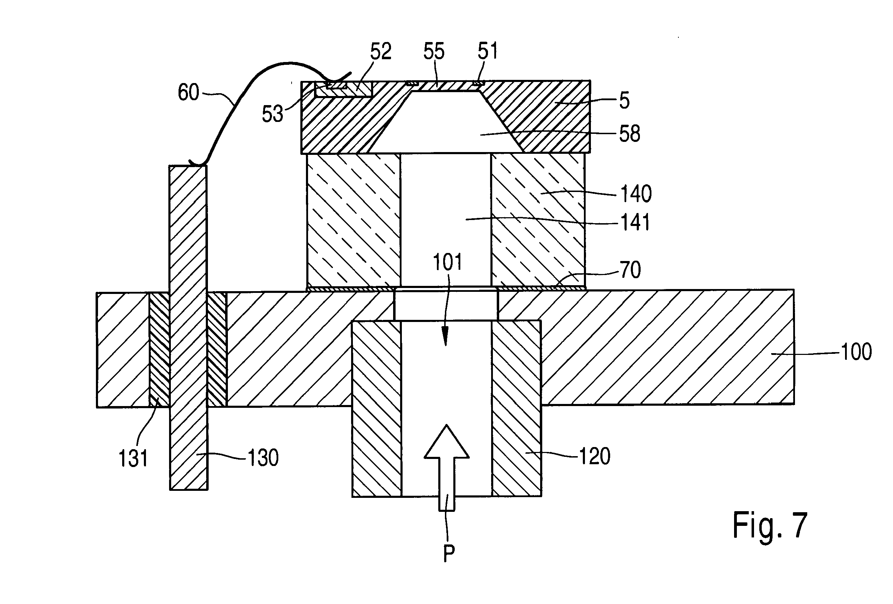

Fig. 7 zeigt ein erstes Beispiel für ein Verfahren zum Montieren von Halbleiterchips und eine entsprechenden Halbleiterchipanordnung in Querschnittsansicht.

In Fig. 7 bezeichnet Bezugszeichen 100 einen TO8-Sockel, der beispielsweise aus Kovar hergestellt ist. Bezugszeichen 5 ist ein mikromechanischer Silizium-Drucksensorchip mit piezoresistiven Wandlerelementen 51, die auf einer Membran 55 untergebracht sind. Zur Herstellung der Membran 55 wird eine Kaverne 58 auf der Rückseite des betreffenden Silizium-Drucksensorchips 5 eingebracht, beispielsweise durch anisotropes Ätzen, z.B. mit KOH oder TMAH. Alternativ kann die Membran 55 auch durch Trench-Ätzen hergestellt werden.

Der Sensorchip 5 kann aus einer reinen Widerstandsbrücke mit piezoresistiven Widerständen bestehen oder kombiniert sein mit einer Auswerteschaltung, die zusammen mit den Piezowiderständen in einen Halbleiterprozess integriert wird. Ein Glassockel 140 aus natriumhaltigen Glas, der auf die Rückseite des Chips 5 anodisch gebondet ist, dient zur Reduzierung von mechanischer Spannung, die durch Lot oder Kleber 70 hervorgerufen wird, mittels dem der Glassockel 140 auf dem TO8-Sockel 100 aufgebracht ist. Bezugszeichen 53 in Fig. 7 bezeichnet ein Bondpad einer nicht näher dargestellten integrierten Schaltung 52, das über einen Bonddraht 60 mit einer elektrischen Anschlusseinrichtung 130 verbunden ist, welche wiederum durch eine Isolationsschicht 131 von dem TO8-Sockel 100 isoliert ist. Der Glassockel 140 weist eine Durchgangsöffnung 141 auf, welche die Kaverne 58 über eine Durchgangsöffnung 101 des TO8-Sockels 100 und eine daran angesetzte Anschlusseinrichtung 120 mit dem extern herrschenden Druck P verbindet. Der in Fig. 7 gezeigte Aufbau wird üblicherweise noch mit einer nicht gezeigten Metallkappe hermetisch dicht verschweisst.

Allerdings weist ein derartiger Aufbau den Nachteil auf, dass er umständlich ist und häufig Probleme beim hermetischen Einschliessen des Sensorchips 5 auftreten, beispielsweise wegen undichter Schweissnähte, o.ä. Da das TO8-Gehäuse und das Silizium unterschiedliche Temperaturausdehnungskoeffizienten haben, entstehen mechanische Spannungen bei Temperaturwechseln, die von Piezowiderständen als Störsignal gemessen werden.

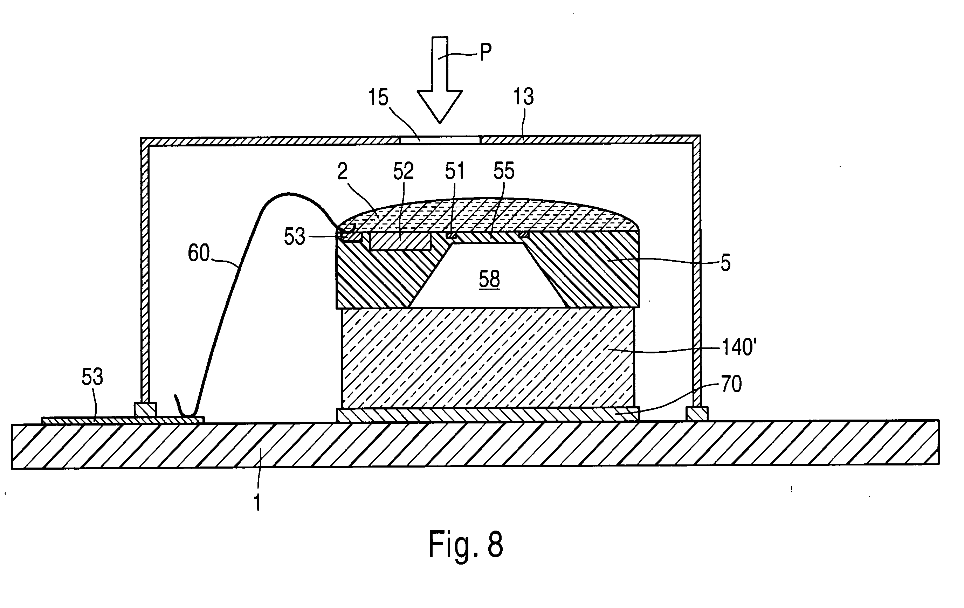

Fig. 8 zeigt ein zweites Beispiel für ein Verfahren zum Montieren von Halbleiterchips und eine entsprechenden Halbleiterchipanordnung in Querschnittsansicht.

Dieses zweite Beispiel sieht vor, den Sensorchip 5 über einen Glassockel 140', der keine Durchgangsöffnung aufweist, auf ein Substrat 1 aus einer Keramik oder Kunststoff zu kleben und zum Schutz gegen Umwelteinflüsse mit einem Gel 2 zu passivieren. Zusätzlich vorgesehen über der Chipanordnung auf dem Substrat 1 ist eine Schutzkappe 13 mit einer Durchgangsöffnung 15 für den anzulegenden Druck P. Auch weist der Glassockel 140' bei diesem Beispiel keine Durchgangsöffnung auf, da der Druck P von der anderen Seite angelegt wird.

Bei Verwendung eines solchen Gels 2 wird der Maximaldruck nachteiligerweise durch das Gel 2 bestimmt, da Gas in das Gel 2 eindiffundiert und bei plötzlicher Druckerniedrigung Gasblasen im Gel 2 entstehen, die das Gel 2 zerstören.

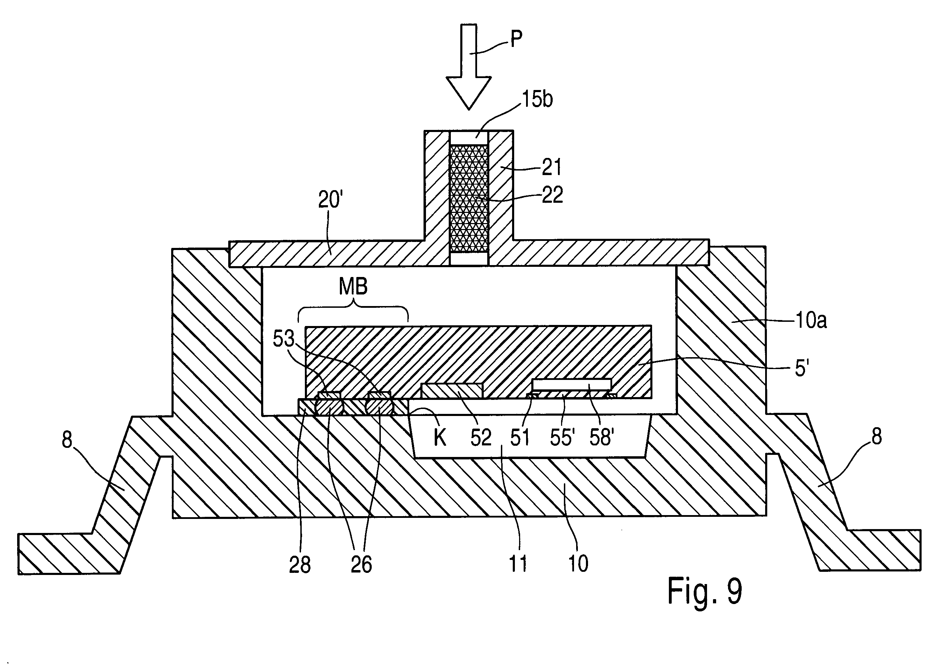

Fig. 9 zeigt ein drittes Beispiel für ein Verfahren zum Montieren von Halbleiterchips und eine entsprechenden Halbleiterchipanordnung in Querschnittsansicht.

Bei diesem Beispiel ist der Sensorchip 5' ein oberflächenmikromechanischer Sensorchip, welcher beispielsweise gemäß dem in der DE 100 32 579 A1 beschriebenen Verfahren hergestellt wurde und eine integrierte Kaverne 58' über einem Membranbereich 55' aufweist.

Zur Montage werden Bondpads 53 des Sensorchips 5' in einem Montagebereich mittels einer Lot- oder Klebeverbindung , z.B. Lotkügelchen 26, auf (nicht gezeigte) Bondpads des Substrat gelötet, das Teil eines Premoldgehäuses 10 aus Kunststoff ist, aus dem seitlich ein darin eingeformter Leadframe 8 herausragt. Das Premoldgehäuse 10 weist eine Aussparung 11 auf, neben der der Sensorchip 5 in Flip-Chip-Technik überhängend montiert ist.

Der minimale Abstand von Konatktbereichen des Leadframes 8 im Montagebereich des Sensorchips 5 ist meist großer als der minimale Abstand der Bondpads 53 auf dem Sensorchip 5. Da aber nur wenig Bondpads 53 auf dem Sensorchip 5 nötig sind, z.B. vier Stück für den Anschluß einer Wheatston'schen Messbrücke, können diese so weit wie nötig voneinander entfernt plaziert werden.

Der Montagebereich weist zusätzlich eine Unterfüllung 28 aus einem isolierenden Kunststoffinaterial auf, wobei die Kante K der Aussparung 11, die zwischen Montagebereich und Membranbereich 55' liegt, als Abrisskante für die Unterfüllung 28 beim Montageprozess dient. Die Abrisskante K sorgt dafür, dass die Unterfüllung 28 nicht in bzw. unter den Membranbereich 55' gelangen kann. Der Membranbereich 55' des Sensorchips 5' ragt dadurch seitlich neben dem streifenförmigen Montagebereich hinaus, so dass das Druckmedium ungestört an den Membranbereich 55' gelangen kann.

Der Sensorchip 5' ist im Membranbereich 55' auf der Oberfläche durch eine (nicht gezeigte) Schich, z.B. eine Nitridschicht, passiviert, die als sicherer Medienschutz wirkt. Im Montagebereich ist der Sensorchip 5' durch die Unterfüllung 28 vor Korrosion geschützt.

Schliesslich weist das Premoldgehäuse 10 einen ringförmigen Seitenwandbereich 10a auf, an dessen Oberseite ein Deckel 20' mit einer Durchgangsöffnung 15b für den anzulegenden Druck P vorgesehen ist. Aufgund der Tatsache, dass der Sensorchip 5' durch die Flip-Chip-Montage auf der dem Montagebereich gegenüberliegenden Seite des Peripheriebereichs von der Oberseite des Premoldgehäuses 10 beabstandet ist, wird eine problemlose Übertragung des angelegten Drucks P auf den Membranbereich 55 gewährleistet.

Ferner weist der Deckel 20' einen Druckanschlussstutzen 21 auf, wobei in der Durchgangsöffnung 15b ein optionales Filter 22 eingebaut sein kann, das verhindert, dass Partikel oder flüssige Medien ins Innere der Sensorverpackung gelangen können. So kann beispielsweise verhindert werden, dass Wasser eindringt, welches beim Gefrieren den Sensorchip 5' absprengen und damit zerstören könnte.

Bei diesem Beispiel kann der Glassockel 140, 140' gemäss Fig. 7 bzw. 8, der bei der Herstellung erhebliche Kosten mit sich bringt, vollständig weggelassen werden, da das seitliche Hinausragen des oberflächenmikromechanischen Sensorchips 5' neben dem streifenförmigen Montagebereich bereits den Abbau der Spannung ermöglicht, die durch unterschiedliche Temperaturausdehnungskoeffizienten von Silizium und der Verbindung mit den Lotkügelchen 26 und der Unterfüllung 28 entsteht.

### VORTEILE DER ERFINDUNG

Die der vorliegenden Erfindung zugrunde liegende Idee besteht in einer überhängenden Aufbauweise eines Halbleiterchips, insbesondere Oberflächenmikromechanik(OMM)-Differenzdrucksensorchips, auf einem Substrat mit einer Aussparung mittels einer Flip-Chip-Montagetechnik, wobei eine mechanische Entkopplung des Halbleiterchips durch das seitliche Überhängen vorgesehen ist.

Das erfindungsgemässe Verfahren zum Montieren von Halbleiterchips mit den Merkmalen des Anspruchs 1 und die entsprechende Halbleiterchipanordnung gemäss Anspruch 8 weisen gegenüber den bekannten Lösungsansätzen den Vorteil auf, dass ein einfacher kostengünstiger und spannungsunempfindlieher Aufbau ermöglicht wird.

Der Gegenstand der vorliegenden Erfindung weist den weiteren Vorteil auf, dass gegenüber einem Absolutdrucksensor ohne einen zweiten Druckanschluss bis auf einen zusätzlichen kurzen Silizium-Trenchschritt zum Öffnen einer Zugangsöffnung zu einer Kaverne keine weiteren Prozessschritte benötigt werden, was das erfindungsgemäße Verfahren sehr kostengünstig gestaltet. Der Ätzschritt zum Öffnen des zweiten Druckzugangs muss nicht durch den gesamten Sensor erfolgen, sondern nur durch eine geringe Dicke der Membran, was einen kurzen Ätzprozess mit sich bringt.

Ein potenzielles Verstopfen des Verbindungskanals vom Membranhohlraum zum Druckanschlussloch durch Partikel im Medium kann durch ein großflächiges, feinmaschiges Gitter verhindert werden. Der erfindungsgemäße Sensortyp weist einen sehr medienresistenten Aufbau auf, der die elektrischen Anschlüsse, beispielsweise aus Aluminium, durch die Unterfüllung schützt. Es gibt nur Oberflächen aus Silizium oder Siliziumnitrid (Passivierung), an die das Druckmedium gelangen kann. Es ist kein Gel zur Passivierung der elektrischen Chipanschlüsse (Bondpads) nötig.

Eine einkristalline Siliziummembran kann hergestellt werden, deren besonderer Vorteil die hohe mechanische Festigkeit und der hohe K-Faktor von darin dotierten Piezowiderständen ist.

Durch sich verbindendes Lot auf dem Halbleiterchip und dem Substrat wird der Halbleiterchip wegen der Oberflächenspannung des Lots ausgerichtet. Der energetisch günstigste Zustand ist erreicht, wenn das Lot zwischen zwei Kontaktflächen auf Chip und Substrat die kleinste Oberfläche hat. Dies ist erreicht, wenn die beiden Flächen direkt übereinander liegen. Das Druckzugangsloch wird dadurch mittels dieser Selbst justage exakt auf den Chipanschluss justiert. Dadurch können auch sehr kleine Strukturen exakt ausgerichtet werden.

Vorhandene Herstellungsprozesse können größtenteils beibehalten werden, wie z.B. der Halbleiterprozess für die Sensorkomponenten und/oder Auswerteschaltungskomponenten bzw. für Sensorgehäuseteile.

Ein elektrisches Vormessen im Wafer-Verbund ist möglich, ebenso wie ein Bandendeabgleich nach der Montage auf dem Träger. Das erfindungsgemäße Verfahren ermöglicht ebenfalls einen platzsparenden Aufbau von Sensorchip und Auswerteschaltung.

In den Unteransprüchen finden sich vorteilhafte Weiterbildungen und Verbesserungen des jeweiligen Gegenstandes der Ereindung.

Gemäss einer bevorzugten Weiterbildung werden im Montagebereich eine Mehrzahl von Bondpads vorgesehen, welche über eine Lot- oder Klebeverbindung auf der Oberfläche des Substrats montiert werden.

Gemäss einer weiteren bevorzugten Weiterbildung wird die Durchgangsöffnung durch das Substrat zur Öffnung der Kaverne vor dem Montieren des Halbleiterchips vorgesehen.

Gemäss einer weiteren bevorzugten Weiterbildung wird auf der Rückseite des Substrats eine erste Druckanschlusseinrichtung und auf der Vorderseite des Substrats eine zweite Druckanschlusseinrichtung vorgesehen, die derart gestaltet sind, dass unterschiedliche Drucke an die beiden Seiten des Membranbereichs anlegbar sind.

Gemäss einer weiteren bevorzugten Weiterbildung ist das Substrat ein Teil eines vorgefertigten Gehäuses.

Gemäss einer weiteren bevorzugten Weiterbildung ist das Gehäuse ein Premoldgehäuse aus Kunststoff, in das ein Leadframe eingeformt ist.

Gemäss einer weiteren bevorzugten Weiterbildung weist das Gehäuse einen ringförmigen Seitenwandbereich auf, welcher den Sensorchip umgibt und welcher oberhalb der Sensorchips durch einen Deckel mit einer Durchgangsöffnung verschlossen wird.

Gemäss einer weiteren bevorzugten Weiterbildung weist die Kaverne einen ersten Kavernenbereich, einen zweiten Kavernenbereich und einen dritten Kavernenbereich auf, wobei der erste Kavernenbereich unterhalb des Membranbereichs liegt, der dritte Kavernenbereich im Peripheriebereich liegt und die Öffnung zum Substrat aufweist und der zweite Kavernenbereich ein kanalartiger Bereich ist, der den ersten und dritten Kanalbereich verbindet.

Gemäss einer weiteren bevorzugten Weiterbildung weist der zweite Kavernenbereich eine schmale längliche Form auf.

Gemäss einer weiteren bevorzugten Weiterbildung weist der erste Kavernenbereich eine rechteckige, vorzugsweise quadratische Form auf.

Gemäss einer weiteren bevorzugten Weiterbildung geht der zweite Kavernenbereich von einer Ecke des ersten Kavernenbereichs aus.

Gemäss einer weiteren bevorzugten Weiterbildung ist im Membranbereich eine piezoelektrische oder piezoresistive Druckerfassungseinrichtung vorgesehen.

### ZEICHNUNGEN

Ausführungsbeispiele der Erfindung sind in den Zeichnungen dargestellt und in der nachfolgenden Beschreibung näher erläutert.

Es illustrieren:
- Fig. 1 a,b: eine erste Ausführungsform des erfindungsgemässen Verfahren zum Montieren von Halbleiterchips und einer entsprechenden Halbleiterchipanordnung in seitlicher bzw. ebener Querschnittsansicht;
- Fig. 2: eine zweite Ausführungsform des erfindungsgemässen Verfahren zum Montieren von Halbleiterchips und einer entsprechenden Halbleiterchipanordnung in Querschnittsan- sicht;
- Fig.3 3: eine dritte Ausführungsform des erfindungsgemässen Verfahren zum Montieren von Halbleiterchips und einer entsprechenden Halbleiterchipanordnung in Querschnittsan- sicht;
- Fig. 4: eine vierte Ausführungsform des erfindungsgemässen Verfahren zum Montieren von Halbleiterchips und einer entsprechenden Halbleiterchipanordnung in Querschnittsan- sicht;
- Fig. 5,6: eine Ausfiihrungsform des erfindungsgemässen Halbleiterchips als Drucksensor in Querschnittsansicht;
- Fig. 7: ein erstes Beispiel für ein Verfahren zum Montieren von Halbleiterchips und eine ent- sprechenden Halbleiterchipanordnung in Querschnittsansicht;
- Fig. 8: ein zweites Beispiel für ein Verfahren zum Montieren von Halbleiterchips und eine entsprechenden Halbleiterchipanordnung in Querschnittsansicht;
- Fig. 9: ein drittes Beispiel für ein Verfahren zum Montieren von Halbleiterchips und eine ent- sprechenden Halbleiterchipanordnung in Querschnittsansicht.

### BESCHREIBUNG DER AUSFÜHRUNGSBEISPIELE

In den Figuren bezeichnen gleiche Bezugszeichen gleiche oder funktionsgleiche Komponenten.

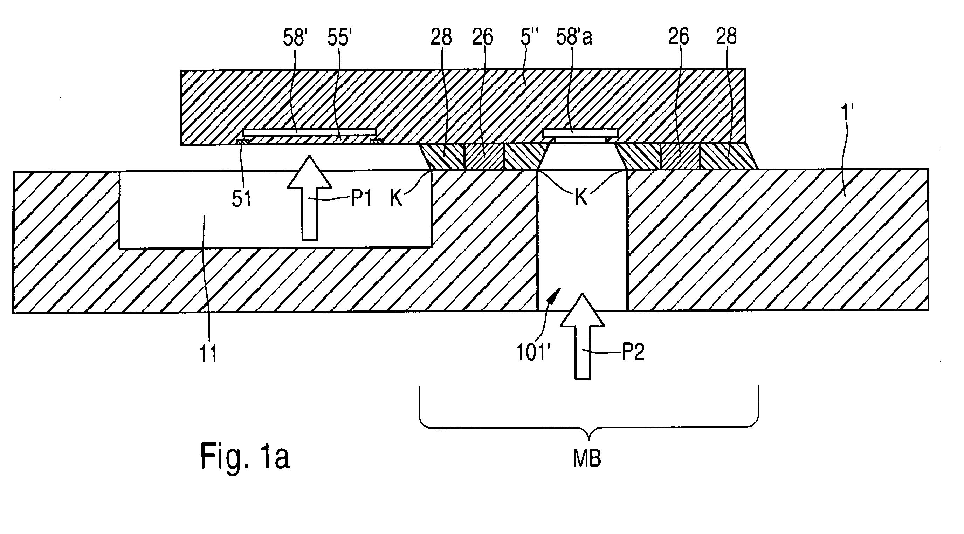

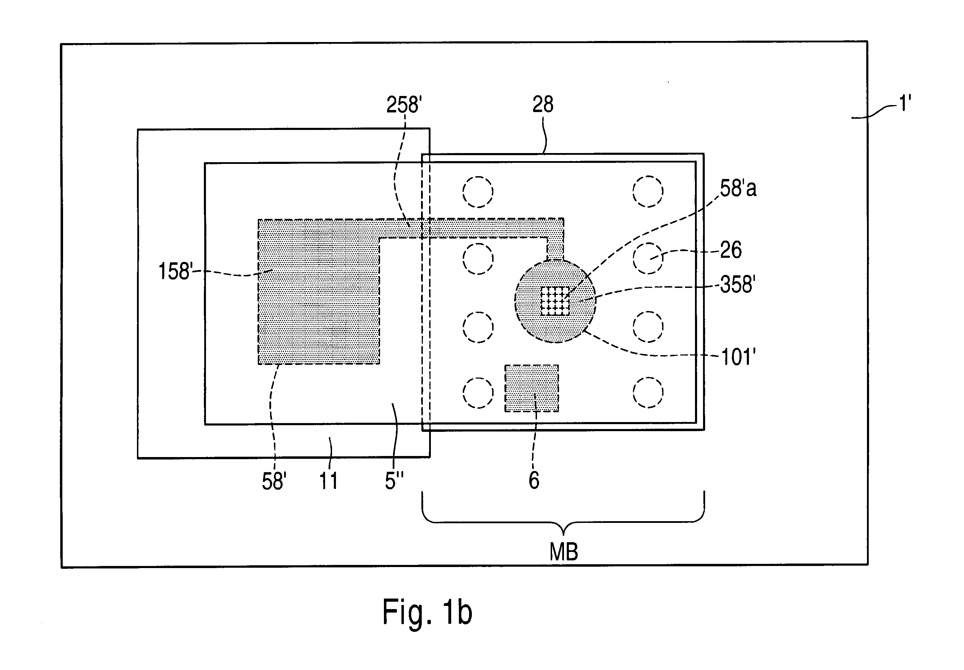

Fig. 1a,b zeigen eine erste Ausführungsform des erfindungsgemässen Verfahren zum Montieren von Halbleiterchips und einer entsprechenden Halbleiterchipanordnung in seitlicher bzw. ebener Querschnittsansicht.

Bei diesem Beispiel ist der Sensorchip 5" ein oberflächenmkomechanischer Sensorchip, welcher beispielsweise gemäß dem in der DE 100 32 579 A1 beschriebenen Verfahren hergestellt wurde und eine integrierte Kaverne 58' über einem Membranbereich 55' aufweist.

Zur Montage werden Bondpads des Sensorchips 5" in einem Montagebereich MB mittels einer Lot-oder Klebeverbindung , z.B. Lotkügelchen 26, auf (nicht gezeigte) Bondpads des Substrat 1' gelötet, das hier eine Leiterplatte oder Keramik ist und das eine Aussparung 11 aufweist, neben der der Sensorchip 5" in Flip-Chip-Technik überhängend montiert ist.

Der Montagebereich MB weist zusätzlich eine Unterfüllung 28 aus einem isolierenden Kunststoffmaterial auf, wobei die Kante K der Aussparung 11, die zwischen Montagebereich und Membranbereich 55' liegt, als Abrisskante für die Unterfüllung 28 beim Montageprozess dient. Die Abrisskante K sorgt dafür, dass die Unterfüllung 28 nicht in bzw. unter den Membranbereich 55' gelangen kann. Der Membranbereich 55' des Sensorchips 5" ragt dadurch seitlich neben dem streifenförmigen Montagebereich hinaus, so dass das Druckmedium mit dem Druck P1 ungestört an den Membranbereich 55' gelangen kann.

Der Sensorchip 5" ist im Membranbereich 55' auf der Oberfläche durch eine (nicht gezeigte) Sicht, z.B. eine Nitridschicht, passiviert, die als sicherer Medienschutz wirkt. Im Montagebereich ist der Sensorchip 5" durch die Unterfüllung 28 vor Korrosion geschützt.

Im Unterschied zur oben im Zusammenhang mit Fig. 9 beschriebenen Konstruktion weist der Sensorchip 5" eine unterschiedlich Struktur der Kaverne 58' auf, welche Fig. 1b entnehmbar ist. Insbesondere weist die Kaverne 58' einen ersten Kavernenbereich 158', einen zweiten Kavernenbereich 258' und einen Kavernenbereich 358' auf. Der erste Kavernenbereich 158' liegt unterhalb des Membranbereichs 55', wie aus Fig. 9 bekannt. Der zusätzliche dritte Kavernenbereich 358' liegt im Peripheriebereich, nämlich hier inmitten des Montagebereichs MB und enthält eine Öffnung 58'a, welche die Kaverne 58' nach außen für eine Druckbeaufschlagung zugänglich macht. Weiterhin ist bei dieser Ausführungsform der zweite Kavernenbereich 258' ein kanalartiger Bereich, der den ersten und dritten Kavernenbereich 158', 358' verbindet.

Der erste Kavernenbereich 158' weist bei dieser Ausführungsform eine quadratische Form auf, wobei der zweite Kavernenbereich 258' von einer Ecke des ersten Kavernenbereichs 158' ausgeht. Dies ist hinsichtlich der Verhinderung möglicher Stresseinkopplung des zweiten Kavernenbereichs 258' in die Piezowiderstände 51 von Vorteil.

Der dritte Kavernenbereich 358' ist beim vorliegenden Beispiel rund und weist, wie in Fig. 1b zu sehen, eine gitterformige Öffnung 58'a auf, wobei die Gitterstruktur erforderlich ist, ein Eindringen von Fremdpartikeln in die Kaverne 58' bzw. ein Zusetzen des Kanalbereichs zu verhindern.

Das Substrat 1' weist unterhalb der Öffnung 58'a eine Durchgangsöffnung 101' auf, welche eine Einkopplung von Druck P2 durch das Substrat 1' in die Kaverne 58' ermöglicht. Auch den Bereich der Durchgangsöffnung 101' gelangt bei der bereits im Zusammenhang mit Fig. 9 beschriebenen Flip-Chip-Montage keine Unterfüllung 28. Es entsteht dadurch wieder eine Kante am Substrat 1', an der sich ein Meniskus ausbildet, und die Unterfüllung 28 stoppt.

Gemäß Fig. 1b ist die Auswerteschaltung 6 im Montagbereich MB des Chips 5" integriert. Selbstverständlich ist auch eine Lösung mit einem separaten Auswertechip denkbar.

Durch den geschilderten Aufbau dieser Ausführungsform ist es möglich, auf die eine Seite des Membranbereichs 55' durch die Aussparung 11 einen ersten Druck P1 und an die andere Seite des Membranbereichs 55' durch die Durchgangsöffnung 101' einen zweiten Druck P2 anzulegen. Somit eignet sich die geschilderte Ausführungsform insbesondere für eine Differenzdruck-Sensorvorrichtung.

Nachstehend werden zwei Ausführungsformen geschildert, aus denen entnehmbar ist, wie die unterschiedlichen Drucke P1, P2 zweckmäßigerweise unabhängig voneinander an die beiden Seiten des Membranbereichs 55' anlegbar sind.

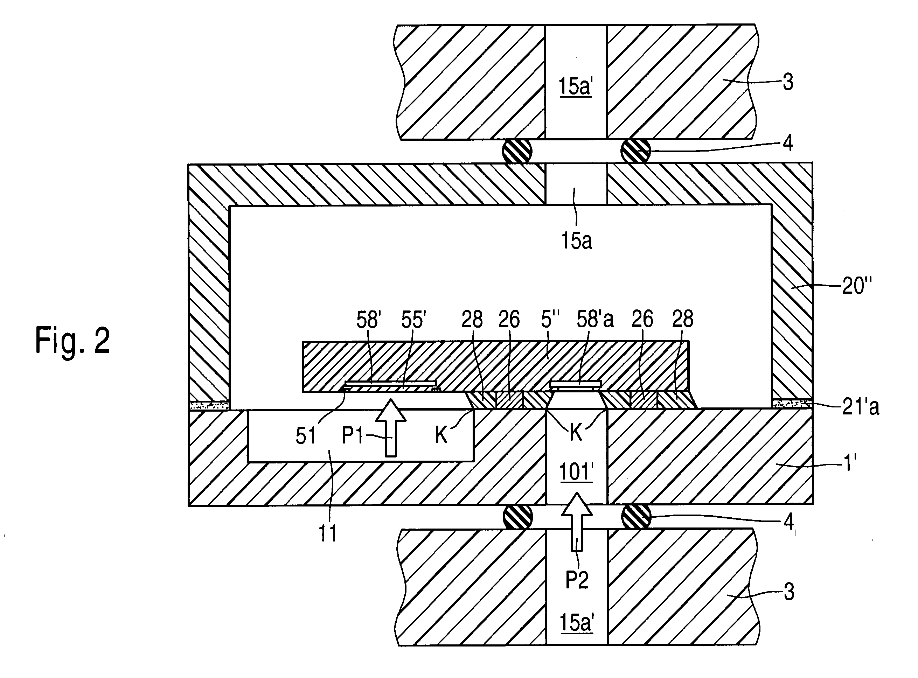

Fig. 2 zeigt eine zweite Ausführungsform des erfindungsgemässen Verfahren zum Montieren von Halbleiterchips und einer entsprechenden Halbleiterchipanordnung in Querschnittsansicht.

Bei der Ausführungsform gemäß Fig. 2 ist auf dem Substrat 1' ein Deckel 20" mittels eines Klebers 21'a vorgesehen. Der Deckel 20' weist eine Öffnung 15a auf.

Die Druckanschlusseinrichtung weist in diesem Fall eine Gehäuseeinrichtung 3 auf, die an der Öffnung 15a und der Öffnung 101', mittels einer O-Ringeinrichtung 4 angeflanscht ist und entsprechende Drucköffnungen 15a' aufweist. Somit gelangt der Druck P1 nur an die Vorderseite des Membranbereichs 55` und der Druck P2 an die Rückseite des Membranbereichs 55'.

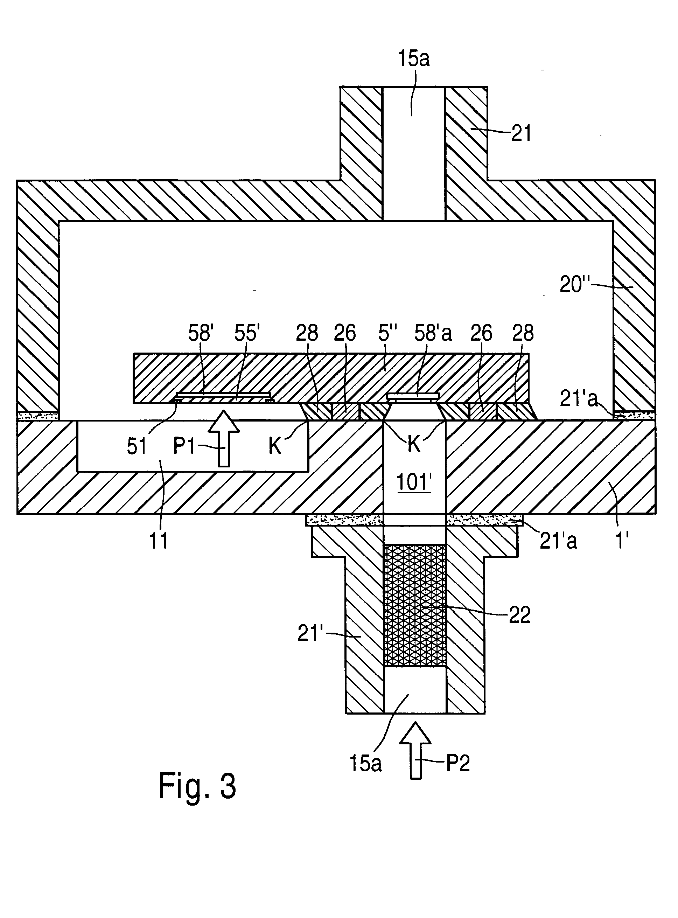

Fig. 3 zeigt eine dritte Ausführungsform des erfindungsgemässen Verfahren zum Montieren von Halbleiterchips und einer entsprechenden Halbleiterchipanordnung in Querschnittsansicht.

Bei der in Fig 3. gezeigten Ausführungsform ist ebenfalls der Deckel 20' vorgesehen, dieser weist jedoch hier einen Druckanschlussstutzen 21 mit einer Öffnung 15a auf. Rückseitig ist bei dieser Ausführungsform ein weiterer Druckanschlussstutzen 21' vorgesehen, der über eine Klebeschicht 21'a auf die Rückseite des Substrats 1' geklebt ist. Im Druckanschlussstutzen 21' zusätzlich vorgesehen ist ein optionaler Filter 22.

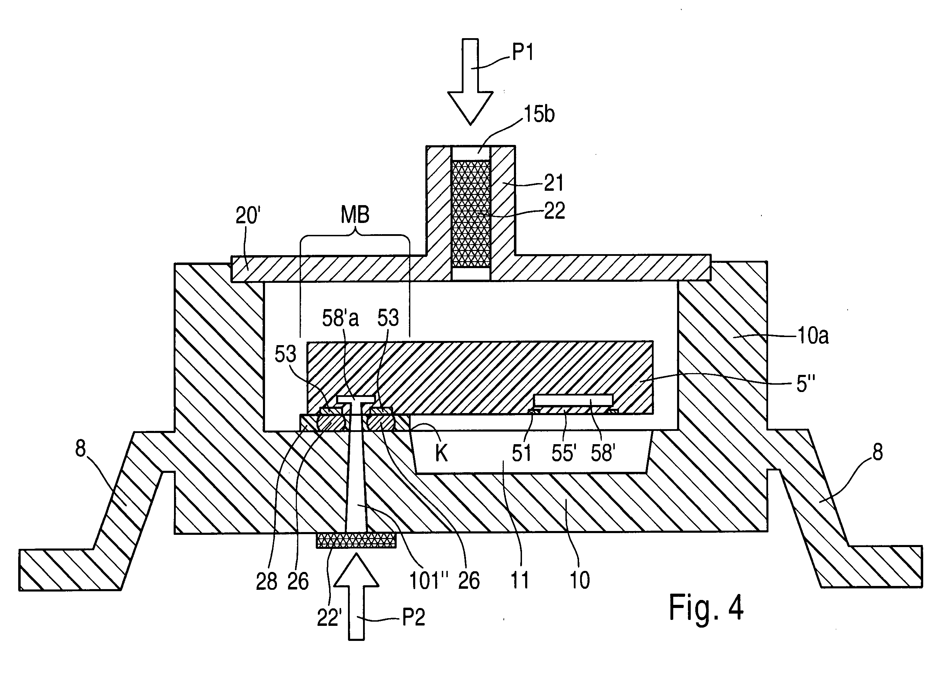

Fig. 4 zeigt eine vierte Ausführungsform des erfindungsgemässen Verfahren zum Montieren von Halbleiterchips und einer entsprechenden Halbleiterchipanordnung in Querschnittsansicht.

Die in Fig. 4 gezeigte Ausführungsform basiert auf dem in Zusammenhang mit dem in Fig. 9 beschriebenen Beispiel.

Allerdings weist auch hier der Sensorchip 5" die modifizierte Kaverne 58' auf, welche bereits in Zusammenhang mit Fig. 1b ausfürhrlich erläutert wurde.

Das Premoldgehäuse 10 weist auf seiner Rückseite eine Durchgangsöffnung 101 " auf, auf der von außen ein optionaler Filter 22' aufgeklebt ist. Durch die Durchgangsöffnung 101" kann der Druck P2 an die Rückseite des Membranbereichs 55 gelangen.

Wie bereits in Zusammenhang mit Fig. 9 beschrieben, kann der Druck P1 durch den Anschlussstutzen 21 und den darin befindlichen optionalen Filter 22 an die Vorderseite des Membranbereichs 55' gelangen.

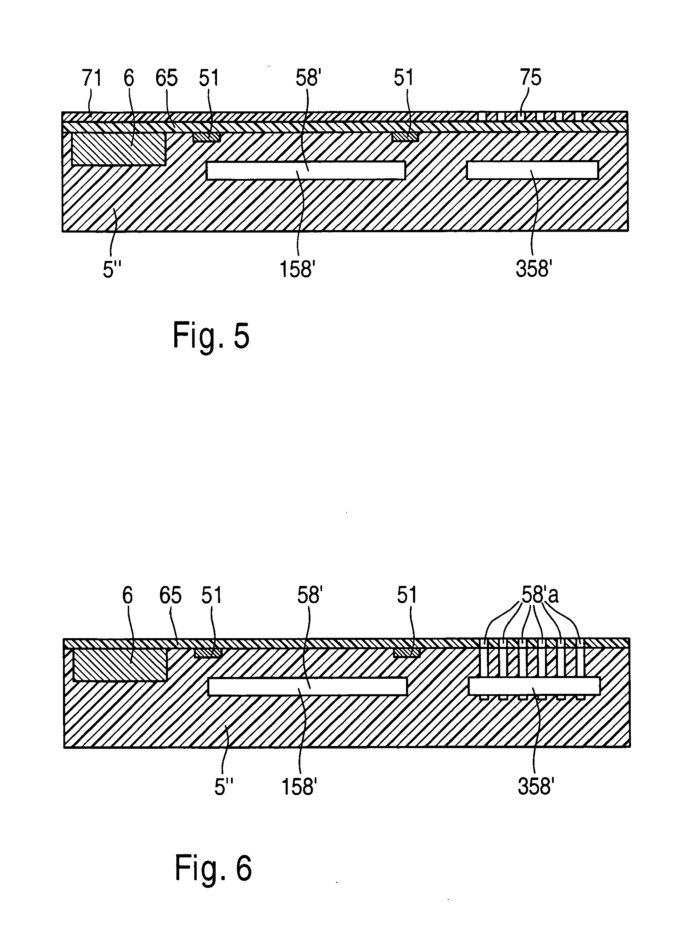

Fig. 5,6 zeigen eine Ausführungsform des erfindungsgemässen Absoltut- bzw. Differenz-Drucksensors in Querschnittsansicht.

In Fig. 5 und 6 beschrieben ist die Herstellung der gitterartigen Öffnung 58'a (vgl. Fig. 1b) vor der Flip-Chip-Montage des Sensorchips 5".

Gemäß Fig. 5 wird auf der Vorderseite des Chips 5" zunächst eine Passivierungsschicht 65, z.B. aus Siliziumnitrid, aufgebracht und darüber eine Photolackschicht 71, die im betreffenden Bereich in Form eines Gitters 75 in üblicher Weise photolithographisch strukturiert wird.

Unter Zuhilfenahme dieser strukturierten Photolackschicht 71 als Maske kann dann eine Ätzung zum Erfolgen der gitterartigen Öffnung 58'a erfolgen. Ein großer Vorteil bei diesem Trenchätzprozess ist, dass nur die Dicke der Passivierungsschicht 65 und der Deckschicht aus Silizium oberhalb des Kavernenbereichs 358' geätzt werden muss und nicht die gesamte Dicke des Siliziumchips 5" wie beim Stand der Technik. Da der Ätzvorgang beim Erreichen des dritten Kavernenbereichs 358' nicht stoppt, wird das darunter liegende Silizium angeätzt, wie sich in Fig. 6 deutlich erkennen lässt. Durch diesen prinzipiell nicht störenden Effekt kann eine ausreichend lange Überätzzeit eingestellt werden, so dass gewährleistet ist, dass über den gesamten Wafer die entsprechenden Öffnungen 58'a zu den Kavernen 58 sicher geöffnet werden.

Obwohl die vorliegende Erfindung vorstehend anhand bevorzugter Ausführungsbeispiele erläutert worden ist, ist sie nicht darauf beschränkt, sondern auch in anderer Weise ausführbar.

In den obigen Beispielen wurden nur piezoresistive Sensorstrukturen betrachtet. Die Erfindung ist jedoch auch für kapazitive oder sonstige Sensorstrukturen geeignet, bei denen Membranen verwendet werden.

Die Geometrie der Membran kann beliebig gestaltet werden, vorzugsweise jedoch quadratisch, rechteckig oder rund.

### BEZUGSZEICHENLISTE:

| | |
|---|---|
| 1,1' | Substrat |
| 2 | Gel |
| 100 | TO8-Sockel |
| 5,5',5" | Sensorchip |
| 6 | Auswertechip |
| 51 | Piezowiderstand |
| 52 | integrierte Schaltung |
| 53 | Bondpad |
| 60 | Bonddraht |
| 55,55' | Membran |
| 70 | Lotschicht oder Klebeschicht |
| 120 | Druckanschlusseinrichtung |
| 130 | elektrische Anschlusseinrichtung |
| 131 | Isolationsschicht |
| 140,140' | Glassockel |
| 141 | Bohrung |
| 58,58' | Kaverne |
| 13 | Schutzkappe |
| 15,15a,15a',15b | Durchgangsöffnung |
| 101,101',101" | Durchgangsöffhung |
| 20,20',20" | Deckel |
| 26 | Lotkügelchen |
| 28 | Unterfüllung |
| 10,10' | Premoldgehäuse |
| 10a | Seitenwandbereich |
| 8 | Leadframe |
| 11,11' | Aussparung |
| 58'a | Öffnung |
| K | Kante |
| 21,21' | Druckanschlussstutzen |
| 22,22' | Filter |
| MB | Montagebereich |
| 158' | erster Kavernenbereich |
| 258' | zweiter Kavernenbereich |
| 358' | dritter Kavernenbereich |
| P,P1,P2 | Druck |
| 3 | Gehäuse |
| 4 | O-Ring |
| 21'a | Kleber |
| 65 | Chippassivierung |
| 71 | Photolack |
| 75 | Gitter |

## Patentansprüche

1. Verfahren zum Montieren von Halbleiterchips mit den Schritten:
Bereitstellen eines Halbleiterchips (5") mit einer Oberfläche, die einen Membranbereich (55') und einen Peripheriebereich aufweist, wobei der Peripheriebereich einen Montagebereich (MB) aufweist, und wobei unter dem Membranbereich (55') eine Kaverne (58') ist, die sich bis in den Montagebereich (MB) erstreckt und dort in einer Öffnung (58'a) mündet;
Vorsehen eines Substrats (1'; 10), welches eine Oberfläche mit einer Aussparung (11) aufweist;
Montieren des Montagebereichs (MB) des Halbleiterchips (5") in Flip-Chip-Technik auf die Oberfläche des Substrats (1'; 10) derart, dass eine Kante (K) der Aussparung (11) zwischen dem Montagebereich (MB) und dem Membranbereich (55') liegt und die Öffnung (58'a) zum Substrat (1'; 10) gerichtet ist;
Unterfüllen des Montagebereichs (MB) mit einer Unterfüllung (28), wobei die Kante (K) der Aussparung (11) als Abrissbereich für die Unterfüllung (28) dient, so dass keine Unterfüllung (28) in den Membranbereich (55) gelangt; und
Vorsehen einer Durchgangsöffnung (101'; 101 ") durch das Substrat (1'; 10) zur Öffnung (58'a) der Kaverne (58').

2. Verfahren nach Anspruch 1, **dadurch gekennzeichnet, dass** im Montagebereich (MB) eine Mehrzahl von Bondpads (53) vorgesehen ist, welche über eine Lot- oder Klebeverbindung auf der Oberfläche des Substrats (1'; 10) montiert werden.

3. Verfahren nach Anspruch 1 oder 2, **dadurch gekennzeichnet, dass** die Durchgangsöffnung (101'; 101 ") durch das Substrat (1'; 10) zur Öffnung (58'a) der Kaverne (58') vor dem Montieren des Halbleiterchips (5") vorgesehen wird.

4. Verfahren nach Anspruch 1, 2 oder 3, **dadurch gekennzeichnet, dass** auf der Rückseite des Substrats (1'; 10) eine erste Druckanschlusseinrichtung (3, 4; 21'; 22') und auf der Vorderseite des Substrats (1'; 10) eine zweite Druckanschlusseinrichtung (3, 4, 20"; 20", 21; 20', 21) vorgesehen wird, die derart gestaltet sind, dass unterschiedliche Drucke (P1, P2) an die beiden Seiten des Membranbereichs (55') anlegbar sind.

5. Verfahren nach mindestens einem der vorhergehenden Ansprüche, **dadurch gekennzeichnet, dass** das Substrat (1'; 10) ein Teil eines vorgefertigten Gehäuses (10) ist.

6. Verfahren nach mindestens einem der vorhergehenden Ansprüche, **dadurch gekennzeichnet, dass** das Gehäuse (10) ein Premoldgehäuse aus Kunststoff ist, in das ein Leadframe (8) eingeformt ist.

7. Verfahren nach Anspruch 5 oder 6, **dadurch gekennzeichnet, dass** das Gehäuse (10) einen ringförmigen Seitenwandbereich (10a) aufweist, welcher den Sensorchip (5") umgibt und welcher oberhalb der Sensorchips (5") durch einen Deckel (20'; 20") mit einer Durchgangsöffnung (15a; 15b) verschlossen wird.

8. Halbleiterchipanordnung mit:
einem Halbleiterchip (5") mit einer Oberfläche, die einen Membranbereich (55') und einen Peripheriebereich aufweist, wobei der Peripheriebereich einen Montagebereich (MB) aufweist, und wobei unter dem Membranbereich (55') eine Kaverne (58') ist, die sich bis in den Montagebereich (MB) erstreckt und dort in einer Öffnung (58'a) mündet;
einem Substrat (1'; 10), welches eine Oberfläche mit einer Aussparung (11) aufweist;
wobei der Montagebereich (MB) des Halbleiterchips (5") in Flip-Chip-Technik auf die Oberfläche des Substrats (1'; 10) derart montiert ist, dass eine Kante (K) der Aussparung (11) zwischen dem Montagebereich (MB) und dem Membranbereich (55') liegt und die Öffnung (58'a) zum Substrat (1'; 10) gerichtet ist;
wobei der Montagebereich (MB) mit einer Unterfüllung (28) unterfüllt ist, wobei die Kante (K) der Aussparung (11) als Abrissbereich für die Unterfüllung (28) dient, so dass keine Unterfüllung (28) im Membranbereich (55') vorliegt; und
wobei eine Durchgangsöffnung (101'; 101 ") durch das Substrat (1'; 10) zur Öffnung (58'a) der Kaverne (58') vorgesehen ist.

9. Halbleiterchipanordnung nach Anspruch 8, **dadurch gekennzeichnet, dass** im Montagebereich (MB) eine Mehrzahl von Bondpads (53) vorgesehen ist, welche über eine Lot- oder Klebeverbindung auf der Oberfläche des Substrats (1'; 10) montiert sind.

10. Halbleiterchipanordnung nach Anspruch 8 oder 9, **dadurch gekennzeichnet, dass** auf der Rückseite des Substrats (1'; 10) eine erste Druckanschlusseinrichtung (3, 4; 21'; 22') und auf der Vorderseite des Substrats (1'; 10) eine zweite Druckanschlusseinrichtung (3, 4, 20"; 20", 21; 20', 21) vorgesehen ist, die derart gestaltet sind, dass unterschiedliche Drucke (P1, P2) an die beiden Seiten des Membranbereichs (55') anlegbar sind.

11. Halbleiterchipanordnung nach Anspruch 8, 9 oder 10, **dadurch gekennzeichnet, dass** das Substrat (1'; 10) ein Teil eines vorgefertigten Gehäuses (10) ist.

12. Halbleiterchipanordnung nach mindestens einem der vorhergehenden Ansprüche 8 bis 11, **dadurch gekennzeichnet, dass** das Gehäuse (10) ein Premoldgehäuse aus Kunststoff ist, in das ein Leadframe (8) eingeformt ist.

13. Halbleiterchipanordnung nach Anspruch 11 oder 12, **dadurch gekennzeichnet, dass** das Gehäuse (10) einen ringförmigen Seitenwandbereich (10a) aufweist, welcher den Sensorchip (5") umgibt und welcher oberhalb der Sensorchips (5 ") durch einen Deckel (20'; 20") mit einer Durchgangsöffnung (15a; 15b) verschlossen ist.

14. Halbleiterchipanordnung nach mindestens einem der vorhergehenden Ansprüche 8 bis 13, **dadurch gekennzeichnet, dass** die Kaverne (58') einen ersten Kavernenbereich (158'), einen zweiten Kavernenbereich (258') und einen dritten Kavernenbereich (358') aufweist, wobei der erste Kavernenbereich (158') unterhalb des Membranbereichs (55') liegt, der dritte Kavernenbereich (358') im Peripheriebereich liegt und die Öffnung (58'a) zum Substrat (1'; 10) aufweist und der zweite Kavernenbereich (258') ein kanalartiger Bereich ist, der den ersten und dritten Kavernenbereich (158'; 358') verbindet.

15. Halbleiterchipanordnung nach Anspruch 14, **dadurch gekennzeichnet, dass** der zweite Kavernenbareich (258') eine schmale längliche Form aufweist.

16. Halbleiterchipanordnung nach Anspruch 15, **dadurch gekennzeichnet, dass** der erste Kavernenbereich (158') eine rechteckige, vorzugsweise quadratische Form aufweist.

17. Halbleiterchipanordnung nach Anspruch 16, **dadurch gekennzeichnet, dass** der zweite Kavernenbereich (258') von einer Ecke des ersten Kavernenbereichs (158') ausgeht.

18. Halbleiterchipanordnung nach mindestens einem der vorhergehenden Ansprüche 8 bis 17, **dadurch gekennzeichnet, dass** im Membranbereich (55') eine piezoelektrische oder piezoresistive Druckerfassungseinrichtung (51) vorgesehen ist.

## Claims

1. Method for mounting semiconductor chips, comprising the following steps
providing a semiconductor chip (5") having a surface that has a membrane region (55') and a peripheral region, the peripheral region having a mounting region (MB) and there being a cavity (58') under the membrane region (55'), which cavity extends right into the mounting region (MB) and joins an opening (58'a) there;
providing a substrate (1'; 10) having a surface having a cutout (11);
mounting the mounting region (MB) of the semiconductor chip (5") using flip-chip technology onto the surface of the substrate (1'; 10) in such a way that an edge (K) of the cutout (11) lies between the mounting region (MB) and the membrane region (55') and the opening (58'a) is directed towards the substrate (1'; 10);
underfilling the mounting region (MB) with an underfill (28), the edge (K) of the cutout (11) serving as a cut-off region for the underfill (28), such that no underfill (28) passes into the membrane region (55); and
providing a through-opening (101'; 101") through the substrate (1'; 10) to the opening (58'a) of the cavity (58').

2. Method according to Claim 1, **characterized in that** a plurality of bonding pads (53) are provided in the mounting region (MB), said bonding pads being mounted on the surface of the substrate (1'; 10) by means of a solder connection or adhesive-bonding connection.

3. Method according to Claim 1 or 2, **characterized in that** the through-opening (101'; 101") through the substrate (1'; 10) to the opening (58'a) of the cavity (58') is provided before the semiconductor chip (5") is mounted.

4. Method according to claim 1, 2 or 3, **characterized in that** a first pressure connection device (3, 4; 21'; 22') is provided on the rear side of the substrate (1'; 10) and a second pressure connection device (3, 4, 20"; 20", 21; 20', 21) is provided on the front side of the substrate (1'; 10), which devices are configured in such a way that different pressures (P1, P2) can be applied to the two sides of the membrane region (55').

5. Method according to at least one of the preceding claims, **characterized in that** the substrate (1'; 10) is part of a prefabricated housing (10).

6. Method according to at least one of the preceding claims, **characterized in that** the housing (10) is a premould housing composed of plastic into which a lead frame (8) is moulded.

7. Method according to Claim 5 or 6, **characterized in that** the housing (10) has a ring-shaped side wall region (10a), which surrounds the sensor chip (5") and which is sealed above the sensor chips (5") by a cover (20'; 20") having a through-opening (15a; 15b).

8. Semiconductor chip arrangement comprising:
a semiconductor chip (5") having a surface that has a membrane region (55') and a peripheral region, the peripheral region having a mounting region (MB) and there being a cavity (58') under the membrane region (55'), which cavity extends right into the mounting region (MB) and joins an opening (58'a) there;
a substrate (1'; 10) having a surface having a cutout (11) ;
the mounting region (MB) of the semiconductor chip (5") being mounted using flip-chip technology onto the surface of the substrate (1'; 10) in such a way that an edge (K) of the cutout (11) lies between the mounting region (MB) and the membrane region (55') and the opening (58'a) is directed towards the substrate (1'; 10);
the mounting region (MB) being underfilled with an underfill (28), the edge (K) of the cutout (11) serving as a cut-off region for the underfill (28) such that no underfill (28) is present in the membrane region (55'); and
a through-opening (101'; 101") through the substrate (1'; 10) to the opening (58'a) of the cavity (58') being provided.

9. Semiconductor chip arrangement according to Claim 8, **characterized in that** a plurality of bonding pads (53) are provided in the mounting region (MB), said bonding pads being mounted on the surface of the substrate (1'; 10) by means of a solder connection or adhesive-bonding connection.

10. Semiconductor chip arrangement according to Claim 8 or 9, **characterized in that** a first pressure connection device (3, 4; 21'; 22') is provided on the rear side of the substrate (1'; 10) and a second pressure connection device (3, 4, 20"; 20", 21; 20', 21) is provided on the front side of the substrate (1'; 10), which devices are configured in such a way that different pressures (P1, P2) can be applied to the two sides of the membrane region (55').

11. Semiconductor chip arrangement according to Claim 8, 9 or 10, **characterized in that** the substrate (1'; 10) is part of a prefabricated housing (10).

12. Semiconductor chip arrangement according to at least one of the preceding Claims 8 to 11, **characterized in that** the housing (10) is a premould housing composed of plastic into which a lead frame (8) is moulded.

13. Semiconductor chip arrangement according to Claim 11 or 12, **characterized in that** the housing (10) has a ring-shaped side wall region (10a), which surrounds the sensor chip (5") and which is sealed above the sensor chips (5") by a cover (20'; 20") having a through-opening (15a; 15b).

14. Semiconductor chip arrangement according to at least one of the preceding Claims 8 to 13, **characterized in that** the cavity (58') has a first cavity region (158'), a second cavity region (258') and a third cavity region (358'), the first cavity region (158') lying below the membrane region (55'), the third cavity region (358') lying in the peripheral region and having the opening (58'a) towards the substrate (1'; 10) and the second cavity region (258') being a channel-like region connecting the first and third cavity regions (158'; 358').

15. Semiconductor chip arrangement according to Claim 14, **characterized in that** the second cavity region (258') has a narrow elongate form.

16. Semiconductor chip arrangement according to Claim 15, **characterized in that** the first cavity region (158') has a rectangular, preferably square form.

17. Semiconductor chip arrangement according to Claim 16, **characterized in that** the second cavity region (258') proceeds from a corner of the first cavity region (158').

18. Semiconductor chip arrangement according to at least one of the preceding Claims 8 to 17, **characterized in that** a piezoelectric or piezoresistive pressure detection device (51) is provided in the membrane region (55')

## Revendications

1. Procédé de montage d'une puce semi-conductrice, le procédé comprenant les étapes qui consistent à :
préparer une puce semi-conductrice (5") dont une surface présente une partie en membrane (55') et une partie périphérique, la partie périphérique présentant une partie de montage (MB), une cavité (58') qui s'étend jusque dans la partie de montage (MB) et y débouche dans une ouverture (58'a) étant prévue en dessous de la partie en membrane (55'),
prévoir un substrat (1'; 10) dont une surface présente une découpe (11),
monter la partie de montage (MB) de la puce semi-conductrice (5") par la technique dite "flip chip" sur la surface du substrat (1'; 10) de telle sorte qu'une arête (K) de la découpe (11) soit située entre la partie de montage (MB) et la partie en membrane (55') et que l'ouverture (58'a) soit orientée vers le substrat (1'; 10),
remplir d'une charge (28) la partie située en dessous de la partie de montage (MB), l'arête (K) de la découpe (11) servant de partie d'interruption de la charge (28) de telle sorte que la charge (28) ne pénètre pas dans la partie en membrane (55) et
prévoir à travers le substrat (1'; 10) une ouverture de passage (101'; 101") vers l'ouverture (58'a) de la cavité (58').

2. Procédé selon la revendication 1, **caractérisé en ce que** plusieurs pistes de liaison (53) montées sur la surface du substrat (1'; 10) par une liaison brasée ou collée sont prévues dans la partie de montage (MB).

3. Procédé selon les revendications 1 ou 2, **caractérisé en ce que** l'ouverture de passage (101'; 101") qui traverse le substrat (1'; 10) vers l'ouverture (58'a) de la cavité (58') est ménagée avant le montage de la puce semi-conductrice (5").

4. Procédé selon les revendications 1, 2 ou 3, **caractérisé en ce qu'**un premier système (3, 4; 21'; 22') de raccordement à la pression est prévu sur le côté arrière du substrat (1'; 10) et un deuxième système (3, 4, 20"; 20", 21; 20', 21) de raccordement à la pression est prévu sur le côté avant du substrat (1'; 10) et **en ce que** ces systèmes sont configurés de manière à permettre à des pressions (P1, P2) différentes d'agir sur chacun des deux côtés de la partie en membrane (55').

5. Procédé selon au moins l'une des revendications précédentes, **caractérisé en ce que** le substrat (1'; 10) fait partie d'un boîtier (10) préfabriqué.

6. Procédé selon au moins l'une des revendications précédentes, **caractérisé en ce que** le boîtier (10) est un boîtier pré-moulé en matière synthétique dans lequel est formé un bâti conducteur (8).

7. Procédé selon les revendications 5 ou 6, **caractérisé en ce que** le boîtier (10) présente une partie (10a) de paroi latérale de forme annulaire qui entoure la puce de détecteur (5") et qui est fermée au-dessus de la puce de détecteur (5") par un couvercle (20'; 20") doté d'une ouverture de passage (15a; 15b).

8. Ensemble de puce semi-conductrice qui présente :
une première puce semi-conductrice (5") dont une surface présente une partie en membrane (55') et une partie périphérique, la partie périphérique présentant une partie de montage (MB), une cavité (58') qui s'étend jusque dans la partie de montage (MB) et qui y débouche dans une ouverture (58'a) étant prévue en dessous de la partie en membrane (55'),
un substrat (1'; 10) dont une surface présente une découpe (11),
la partie de montage (MB) de la puce semi-conductrice (5") étant montée par la technique dite "flip chip" sur la surface du substrat (1'; 10) de telle sorte qu'une arête (K) de la découpe (11) soit située entre la partie de montage (MB) et la partie en membrane (55') et que l'ouverture (58'a) soit orientée vers le substrat (1'; 10),
la partie située en dessous de la partie de montage (MB) étant remplie d'une charge (28), l'arête (K) de la découpe (11) servant de partie d'interruption de la charge (28) de telle sorte que la charge (28) ne pénètre pas dans la partie en membrane (55') et
une ouverture de passage (101'; 101") vers l'ouverture (58'a) de la cavité (58') étant ménagée à travers le substrat (1'; 10).

9. Ensemble de puce semi-conductrice selon la revendication 8, **caractérisé en ce que** plusieurs pistes de liaison (53) montées sur la surface du substrat (1'; 10) par une liaison brasée ou collée sont prévues dans la partie de montage (MB).

10. Ensemble de puce semi-conductrice selon les revendications 8 ou 9, **caractérisé qu'**un premier système (3, 4; 21'; 22') de raccordement à la pression est prévu sur le côté arrière du substrat (1'; 10) et un deuxième système (3, 4, 20"; 20", 21; 20', 21) de raccordement à la pression est prévu sur le côté avant du substrat (1'; 10) et en ce que ces systèmes sont configurés de manière à permettre à des pressions (P1, P2) différentes d'agir sur chacun des deux côtés de la partie en membrane (55').

11. Ensemble de puce semi-conductrice selon les revendications 8, 9 ou 10, **caractérisé en ce que** le substrat (1'; 10) fait partie d'un boîtier (10) préfabriqué.

12. Ensemble de puce semi-conductrice selon au moins l'une des revendications 8 à 11 qui précèdent, **caractérisé en ce que** le boîtier (10) est un boîtier pré-moulé en matière synthétique dans lequel est formé un bâti conducteur (8).

13. Ensemble de puce semi-conductrice selon les revendications 11 ou 12, **caractérisé en ce que** le boîtier (10) présente une partie (10a) de paroi latérale de forme annulaire qui entoure la puce de détecteur (5") et qui est fermée au-dessus de la puce de détecteur (5") par un couvercle (20'; 20") doté d'une ouverture de passage (15a; 15b).

14. Ensemble de puce semi-conductrice selon au moins une des revendications 8 à 13 qui précèdent, **caractérisé en ce que** la cavité (58') présente une première partie de cavité (158'), une deuxième partie de cavité (258') et une troisième partie de cavité (358'), la première partie de cavité (158') étant située en dessous de la partie en membrane (55'), la troisième partie de cavité (358') étant située dans la partie périphérique et présentant l'ouverture (58'a) vers le substrat (1'; 10) et la deuxième partie de cavité (258') étant une partie en forme de canal qui relie la première et la troisième partie de cavité (158'; 358').

15. Ensemble de puce semi-conductrice selon la revendication 14, **caractérisé en ce que** la deuxième partie de cavité (258') a une forme étroite et allongée.

16. Ensemble de puce semi-conductrice selon la revendication 15, **caractérisé en ce que** la première partie de cavité (158') a une forme rectangulaire et de préférence carrée.

17. Ensemble de puce semi-conductrice selon la revendication 16, **caractérisé en ce que** la deuxième partie de cavité (258') part d'un coin de la première partie de cavité (158').

18. Ensemble de puce semi-conductrice selon au moins l'une des revendications 8 à 17 qui précèdent, **caractérisé en ce qu'**un dispositif piézoélectrique ou piézorésistif (51) de détection de pression est prévu dans la partie en membrane (55').
